# EUROPEAN PATENT SPECIFICATION

(11) **EP 4 191 884 B1**
(45) Date of publication and mention of the grant of the patent: **18.03.2026**
(21) Application number: 22204938.9
(22) Date of filing: 01.11.2022
(51) Int. Cl.: H03K 5/135, H03K 3/037

(54) **SYNCHRONIZER CIRCUIT**
SYNCHRONISIERSCHALTUNG
CIRCUIT DE SYNCHRONISATION

(30) Priority: 01.12.2021 US 202117457060
(43) Date of publication of application: 07.06.2023
(73) Proprietor: NXP B.V., 5656 AG Eindhoven (NL)
(72) Inventor: Jain, Anshul, 5656AG Eindhoven (NL); Jaiswal, Nitin Kumar, 5656AG Eindhoven (NL); Prakash, Sachin, 5656AG Eindhoven (NL); Borole, Sachin Waman, 5656AG Eindhoven (NL)
(74) Representative: Miles, John Richard

(56) References cited:
- EP-A2- 0 678 990
- US-A1- 2003 126 491
- US-B1- 8 890 594

## Description

### FIELD OF USE

The present disclosure relates generally to electronic circuits, and, more particularly, to a synchronizer circuit.

### BACKGROUND

A multi-clock domain system includes different clock domains and functional circuits operating in different clock domains. Typically, functional circuits associated with a first clock domain generate functional signals that are to be utilized by functional circuits associated with a second clock domain. If such functional signals are directly utilized by the functional circuits of the second clock domain for executing associated functional operations, functional errors may occur in the functional circuits as the functional signals are not synchronized with clock signals of the second clock domain.

US 8,890,594 B1 discloses a system for synchronizing a functional reset between first and second clock domains that operate on first and second clock signals, respectively. The system includes first, second and third synchronizer flip-flops that operate on the second clock signal. US 2003/126491 A1 discloses an interface logic block that is needed to efficiently transfer signals from one frequency clock domain to another. EP 0678 990 A2 discloses a method and apparatus for implementing a zero latency synchronizer that advantageously permits the reliable transfer of data between clock domains by placing a metastability delay in the clock path.

### BRIEF DESCRIPTION OF THE DRAWINGS

The following detailed description of the embodiments of the invention will be better understood when read in conjunction with the appended drawings. The present disclosure is illustrated by way of example, and not limited by the accompanying figures, in which like references indicate similar elements.
FIG. 1 illustrates a schematic block diagram of a multi-clock domain system in accordance with an embodiment of the invention;
FIG. 2 illustrates a schematic circuit diagram of a synchronizer circuit of the multi-clock domain system of FIG. 1 in accordance with an embodiment of the invention;
FIG. 3 represents a timing diagram that illustrates an operation of the synchronizer circuit of FIG. 2 in accordance with an embodiment of the invention;
FIG. 4 illustrates a schematic circuit diagram of the synchronizer circuit of the multi-clock domain system of FIG. 1 in accordance with another embodiment of the invention;
FIG. 5 represents a timing diagram that illustrates an operation of the synchronizer circuit of FIG. 4 in accordance with another embodiment of the invention; and
FIG. 6 represents a flowchart that illustrates a synchronization method for the multi-clock domain system of FIG. 1 in accordance with an embodiment of the invention.

### DETAILED DESCRIPTION

The detailed description of the appended drawings is intended as a description of the embodiments of the present disclosure, and is not intended to represent the only form in which the present disclosure may be practiced. It is to be understood that the same or equivalent functions may be accomplished by different embodiments that are intended to be encompassed within the scope of the invention as defined by the appended claims.

The invention is defined by independent claims 1 and 13 and relates to a multi-clock system with a synchronizer circuit.

The synchronizer circuit according to the invention overcomes the problems of conventional synchronizer circuits by extending and delaying the received functional signal to synchronize the received functional signal with the other clock signal such that the extension of the received functional signal is independent of a ratio of frequencies of the clock signals of both the domains. As a result, functional errors are avoided in the functional circuit utilizing the synchronized functional signal for corresponding functional operations. Further, the synchronizer circuit synchronizes the received functional signal with the other clock signal without any requirement of a feedback signal. Thus, additional circuitry is not required to generate and synchronize the feedback signal, thereby eliminating additional signal routing of the feedback signal. Therefore, the design complexity of the synchronizer circuit of the present disclosure is reduced as compared to conventional synchronizer circuits that include feedback circuitry.

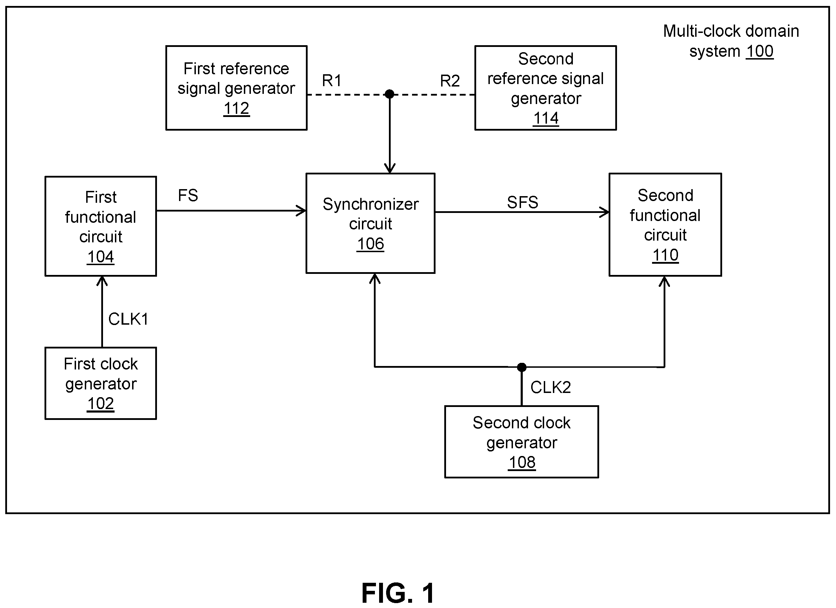

FIG. 1 illustrates a schematic block diagram of a multi-clock domain system 100 in accordance with an embodiment of the invention. The multi-clock domain system 100 may be included on a printed circuit board (PCB) or an integrated circuit (not shown). The multi-clock domain system 100 may include a first clock generator 102, a first functional circuit 104, a synchronizer circuit 106, a second clock generator 108, and a second functional circuit 110. The multi-clock domain system 100 may further include a group consisting of one of a first reference signal generator 112 and a second reference signal generator 114. The multi-clock domain system 100 may be utilized in computing systems, network systems, automotive systems, or the like. Further, examples of the first functional circuit 104 and the second functional circuit 110 may include but are not limited to, a math accelerator, a motor controller, or the like.

The following table illustrates various signals described in FIG. 1:

| **Signal** | **Description** |
|---|---|
| First clock signal CLK1 | Clock signal associated with a first clock domain |
| Functional signal FS | Signal transferred from the first clock domain to a second clock domain |
| First reference signal R1 | Signal having a logic low state |
| Second reference signal R2 | Signal having a logic high state |
| Second clock signal CLK2 | Clock signal associated with the second clock domain |
| Synchronized functional signal SFS | Synchronized version of the functional signal FS |

The first clock generator 102 may include suitable circuitry that may be configured to perform one or more operations. For example, the first clock generator 102 may be associated with a first clock domain and configured to generate a first clock signal CLK1. The first clock generator 102 may generate the first clock signal CLK1 such that the first clock signal CLK1 has a first frequency. Therefore, circuitry (that includes the first functional circuit 104) in the first clock domain may have the first frequency. The first clock generator 102 may be coupled to the first functional circuit 104. The first clock generator 102 may be configured to generate and provide the first clock signal CLK1 to the first functional circuit 104.

The first functional circuit 104 may include suitable circuitry that may be configured to perform one or more operations. The first functional circuit 104 may be associated with the first clock domain. Further, the first functional circuit 104 may be coupled to the first clock generator 102. The first functional circuit 104 may be configured to receive the first clock signal CLK1 from the first clock generator 102 and generate a functional signal FS. The functional signal FS is outputted such that the functional signal FS is synchronized with the first clock signal CLK1. Thus, the functional signal FS has the first frequency.

The synchronizer circuit 106 may be coupled to the first functional circuit 104 and the second clock generator 108. The synchronizer circuit 106 may be configured to receive the functional signal FS and a second clock signal CLK2. The synchronizer circuit 106 may be further configured to be coupled to a group consisting of one of the first reference signal generator 112 and the second reference signal generator 114. The synchronizer circuit 106 may be further configured to receive a reference signal, i.e., one of a group consisting of the first reference signal R1 and the second reference signal R2. The synchronizer circuit 106 may be further configured to output a synchronized functional signal SFS, based on the functional signal FS, the second clock signal CLK2, and one of the first reference signal R1 and the second reference signal R2. The first reference signal R1 may be at a logic low state. Further, the second reference signal R2 may be at a logic high state. The synchronized functional signal SFS is synchronous with the second clock signal CLK2. The synchronized functional signal SFS may be outputted such that the synchronized functional signal SFS is an extended and delayed version of the functional signal FS. In other words, the synchronizer circuit 106 may be configured to extend and delay the functional signal FS that is associated with the first clock signal CLK1. The functional signal FS is extended by a predetermined time duration. In the present embodiment, the predetermined time duration is determined based on the second clock signal CLK2. Thus, the predetermined time duration is greater than one clock cycle of the second clock signal CLK2. Further, the synchronizer circuit 106 may be coupled to the second functional circuit 110 and configured to provide the synchronized functional signal SFS to the second functional circuit 110.

In one scenario, the first reference signal generator 112 may be coupled to the synchronizer circuit 106. Further, the first reference signal generator 112 may be configured to provide the first reference signal R1 to the synchronizer circuit 106. When the synchronized functional signal SFS is received at a logic high state, the second functional circuit 110 is operational, *i.e*., the second functional circuit 110 is configured to operate as an active-high circuit. In another scenario, the second reference signal generator 114 may be coupled to the synchronizer circuit 106. Further, the second reference signal generator 114 may be configured to provide the second reference signal R2 to the synchronizer circuit 106. Thus, the second functional circuit 110 is operational when the synchronized functional signal SFS is received at a logic low state, *i.e*., the second functional circuit 110 is configured to operate as an active-low circuit.

The second clock generator 108 may include suitable circuitry that may be configured to perform one or more operations. For example, the second clock generator 108 may be configured to generate the second clock signal CLK2. The second clock generator 108 may generate the second clock signal CLK2 such that the second clock signal CLK2 has a second frequency. Therefore, a second clock domain may have the second frequency. Further, the second clock generator 108 may be coupled to the synchronizer circuit 106 and the second functional circuit 110. The second clock generator 108 may be configured to generate and provide the second clock signal CLK2 to the synchronizer circuit 106 and the second functional circuit 110. Moreover, the synchronized functional signal SFS, outputted by the synchronizer circuit 106, is synchronized with the second clock signal CLK2, therefore, the synchronized functional signal SFS has the second frequency. In the present embodiment, the first frequency is greater than the second frequency. However, the scope of the present disclosure is not limited to the first frequency being greater than the second frequency. In various embodiments, the second frequency may be greater than the first frequency, without deviating from the scope of the present disclosure.

The second functional circuit 110 may include suitable circuitry that may be configured to perform one or more operations. The second functional circuit 110 may be coupled to the synchronizer circuit 106 and the second clock generator 108. The second functional circuit 110 may be configured to receive the synchronized functional signal SFS from the synchronizer circuit 106 and the second clock signal CLK2 from the second clock generator 108. The second functional circuit 110 may be further configured to perform one or more functional operations associated therewith. Further, the second functional circuit 110 may be associated with the second clock domain such that the second functional circuit 110 may be operated on the second frequency.

The first reference signal generator 112 may include suitable circuitry that may be configured to perform one or more operations. For example, the first reference signal generator 112 may be configured to generate the first reference signal R1 at a logic low state. Further, the first reference signal generator 112 may be coupled to the synchronizer circuit 106 when the second functional circuit 110 is an active-high circuit. The first reference signal generator 112 may be configured to provide the first reference signal R1 to the synchronizer circuit 106.

The second reference signal generator 114 may include suitable circuitry that may be configured to perform one or more operations. For example, the second reference signal generator 114 may be configured to generate the second reference signal R2 at a logic high state. Further, the second reference signal generator 114 may be coupled to the synchronizer circuit 106 when the second functional circuit 110 is an active-low circuit. The second reference signal generator 114 may be further configured to provide the second reference signal R2 to the synchronizer circuit 106.

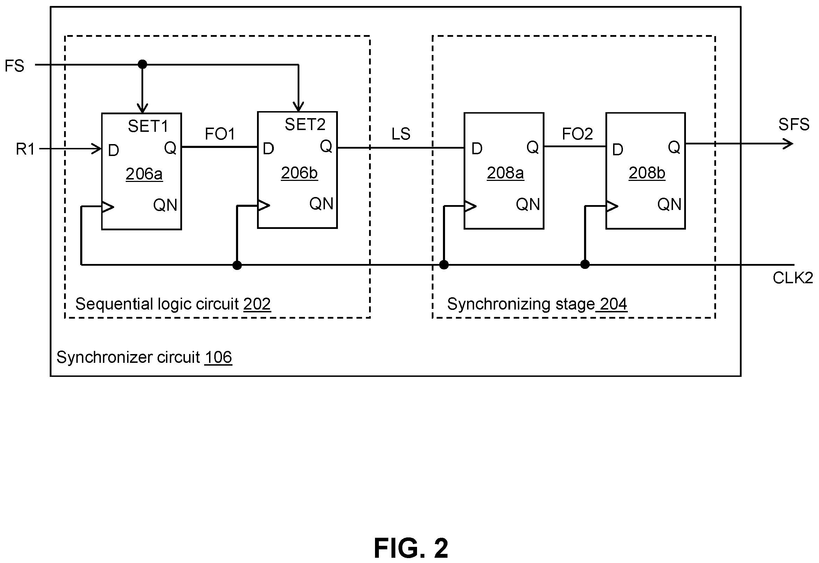

Although in FIG. 1, the first and second reference signal generators 112 and 114 are shown, based on the second functional circuit 110, only one of a group consisting of the first and second reference signal generators 112 and 114 may be present in the multi-clock domain system 100. Further, based on the requirement of the second functional circuit 110, the configuration of the synchronizer circuit 106 may vary. The synchronizer circuit 106 is explained in detail in FIGS. 2 - 6.

FIG. 2 illustrates a schematic circuit diagram of the synchronizer circuit 106 in accordance with an embodiment of the invention. The synchronizer circuit 106 of FIG. 2 may be utilized for active-high functional circuits (*i.e*., the second functional circuit 110). The synchronizer circuit 106 may include a sequential logic circuit 202 and a synchronizing stage 204.

The sequential logic circuit 202 may be coupled to the first functional circuit 104 and the second clock generator 108. The sequential logic circuit 202 may be configured to receive the functional signal FS and the second clock signal CLK2. In other words, the first functional circuit 104 may be coupled to the sequential logic circuit 202 and configured to provide the functional signal FS to the sequential logic circuit 202. Further, in the embodiment of FIG. 2, as the second functional circuit 110 is an active-high circuit, the first reference signal generator 112 may be present in the multi-clock domain system 100. The sequential logic circuit 202 of the synchronizer circuit 106 may be coupled to the first reference signal generator 112. The sequential logic circuit 202 may be further configured to receive the first reference signal R1 and output a logic signal LS. The sequential logic circuit 202 may output the logic signal LS such that the logic signal LS is an extended version of the functional signal FS. In other words, the logic signal LS is activated (*i.e*., is set to a logic high state) in response to the functional signal FS being activated (*i.e*., being set to a logic high state). Further, the logic signal LS remains activated for the predetermined time duration after the deactivation of the functional signal FS (*i.e*., after the functional signal FS transitions to a logic low state). The sequential logic circuit 202 may include first and second flip-flops 206a and 206b. In the present embodiment, the first and second flip-flops 206a and 206b may be coupled in series.

The first flip-flop 206a may have a first input terminal that is coupled to the first reference signal generator 112. The first input terminal of the first flip-flop 206a may be configured to receive the first reference signal R1. The first flip-flop 206a may further have a first control terminal (shown as SET1 in FIG. 2) that is coupled to the first functional circuit 104. The first control terminal may be configured to receive the functional signal FS. In the present embodiment, the first control terminal is a set terminal of the first flip-flop 206a. Further, the first flip-flop 206a may have a first clock terminal that is coupled to the second clock generator 108. The first clock terminal may be configured to receive the second clock signal CLK2. The first flip-flop 206a may further have a first output terminal that is coupled to the second flip-flop 206b. The first output terminal may be configured to output a first flop output signal FO1. In an embodiment, the first output terminal of the first flip-flop 206a may correspond to a positive output terminal, and output an activated first flop output signal FO1 (*i.e*., the first flop output signal FO1 is outputted at a logic high state) when the functional signal FS is activated. The first flop output signal FO1 may be outputted based on the functional signal FS and the first reference signal R1. When the functional signal FS is activated, the first flop output signal FO1 may be outputted based on the functional signal FS. Further, when the functional signal FS is deactivated, the first flop output signal FO1 may be outputted based on the first reference signal R1.

The second flip-flop 206b may have a second input terminal that is coupled to the first flip-flop 206a (*i.e*., the first output terminal). The second input terminal may be configured to receive the first flop output signal FO1. The second flip-flop 206b may further have a second control terminal (shown as SET2 in FIG. 2) that is coupled to the first functional circuit 104. The second control terminal may be configured to receive the functional signal FS. In the present embodiment, the second control terminal is a set terminal of the second flip-flop 206b. Further, the second flip-flop 206b may have a second clock terminal that is coupled to the second clock generator 108. The second clock terminal may be configured to receive the second clock signal CLK2. The second flip-flop 206b may further have a second output terminal that is coupled to the synchronizing stage 204. The second output terminal may be configured to output the logic signal LS. In an embodiment, the second output terminal of the second flip-flop 206b may correspond to a positive output terminal, and output an activated logic signal LS (*i.e*., the logic signal LS is outputted at a logic high state) based on activation of the functional signal FS, i.e., when the functional signal FS is activated. The logic signal LS may be outputted based on the functional signal FS and the first flop output signal FO1. When the functional signal FS is activated, the logic signal LS may be outputted based on the functional signal FS. Further, when the functional signal FS is deactivated, the logic signal LS may be outputted based on the first flop output signal FO1. In the present embodiment, the first and second flip-flops 206a and 206b are D flip-flops, however, the scope of the present disclosure is not limited to it. Moreover, in the embodiment, the sequential logic circuit 202 is shown to include two flip-flops, however, the scope of the present disclosure is further not limited to it. In various embodiments, more than two flip-flops may be utilized in the sequential logic circuit 202, without deviating from the scope of the present disclosure.

In the present embodiment, the functional signal FS, the first flop output signal FO1, and the logic signal LS are activated when the functional signal FS, the first flop output signal FO1, and the logic signal LS are at a logic high state, respectively. Moreover, the functional signal FS, the first flop output signal FO1, and the logic signal LS are deactivated when the functional signal FS, the first flop output signal FO1, and the logic signal LS are at the logic low state. The logic signal LS and the first flop output signal FO1 are activated *(i.e*., at logic high state) when the functional signal FS is activated (*i.e*., at a logic high state). Further, when the functional signal FS subsequently transitions from the logic high state to the logic low state, the first flop output signal FO1 remains at the logic high state until the second clock signal CLK2 transitions from a logic low state to a logic high state. Based on the first reference signal R1, the first flop output signal FO1 transitions from a logic high state to a logic low state when the second clock signal CLK2 transitions (*i.e*., at a rising edge of the second clock signal CLK2) from a logic low state to a logic high state.

When the functional signal FS subsequently transitions from the logic high state to the logic low state, the logic signal LS remains at the logic high state based on the logic high state of the first flop output signal FO1. Further, when the first flop output signal FO1 subsequently transitions from the logic high state to the logic low state, the logic signal LS remains at the logic high state until the second clock signal CLK2 transitions (*i.e*., at a rising edge of the second clock signal CLK2) from one logic state, *i.e*., a logic low state, to another logic state, *i.e*., a logic high state. The predetermined time duration is thus determined based on the transition of the second clock signal CLK2. Therefore, the logic signal LS remains activated for the predetermined time duration after the deactivation of the functional signal FS.

In the present embodiment, the first flop output signal FO1 and the logic signal LS transition from the logic high state to the logic low state when the second clock signal CLK2 transitions from a logic low state to a logic high state (*i.e*., at a rising edge of the second clock signal CLK2). In various other embodiments, the first flop output signal FO1 and the logic signal LS may transition from the logic high state to the logic low state when the second clock signal CLK2 transitions from a logic high state to a logic low state (*i.e*., at a falling edge of the second clock signal CLK2), without deviating from the scope of the present disclosure.

The synchronizing stage 204 may be coupled to the sequential logic circuit 202 and the second clock generator 108. The synchronizing stage 204 may be configured to receive the logic signal LS from the sequential logic circuit 202. Further, the synchronizing stage 204 may be configured to receive the second clock signal CLK2 from the second clock generator 108. The synchronizing stage 204 may be further coupled to the second functional circuit 110. The synchronizing stage 204 may be further configured to output and provide the synchronized functional signal SFS to the second functional circuit 110. Thus, the second functional circuit 110 may be configured to receive the synchronized functional signal SFS from the synchronizing stage 204. The synchronizing stage 204 may output the synchronized functional signal SFS such that the synchronized functional signal SFS is a delayed version of the logic signal LS. The synchronizing stage 204 may include third and fourth flip-flops 208a and 208b. In the present embodiment, the third and fourth flip-flops 208a and 208b may be coupled in series.

The third flip-flop 208a may have a third input terminal that is coupled to the second output terminal of the second flip-flop 206b of the sequential logic circuit 202. The third input terminal may be configured to receive the logic signal LS. The third flip-flop 208a may further have a third clock terminal that is coupled to the second clock generator 108. The third clock terminal may be configured to receive the second clock signal CLK2. Further, the third flip-flop 208a may have a third output terminal that is coupled to the fourth flip-flop 208b. The third output terminal may be configured to output a second flop output signal FO2. In an embodiment, the third flip-flop 208a is a D flip-flop, therefore, the second flop output signal FO2 is a delayed version of the logic signal LS. In the present embodiment, the logic signal LS is delayed until a subsequent rising edge of the second clock signal CLK2 is received by the third flip-flop 208a to output the second flop output signal FO2. However, the scope of the present disclosure is not limited to it. In various embodiments, the logic signal LS may be delayed until a subsequent falling edge of the second clock signal CLK2 is received, to output the second flop output signal FO2. Further, the third flip-flop 208a may be configured to provide the second flop output signal FO2 to the fourth flip-flop 208b.

The fourth flip-flop 208b may have a fourth input terminal that is coupled to the third flip-flop 208a (*i.e*., the third output terminal of the third flip-flop 208a). The fourth input terminal may be configured to receive the second flop output signal FO2. The fourth flip-flop 208b may further have a fourth clock terminal that is coupled to the second clock generator 108. The fourth clock terminal may be configured to receive the second clock signal CLK2. Further, the fourth flip-flop 208b may have a fourth output terminal that is coupled to the second functional circuit 110. The fourth output terminal may be configured to output and provide the synchronized functional signal SFS to the second functional circuit 110. In an embodiment, the fourth flip-flop 208b is a D flip-flop, therefore, the synchronized functional signal SFS is a delayed version of the second flop output signal FO2. In the present embodiment, the second flop output signal FO2 is delayed by one clock cycle of the second clock signal CLK2 to output the synchronized functional signal SFS. Therefore, the logic signal LS is delayed by more than one clock cycle of the second clock signal CLK2 to output the synchronized functional signal SFS.

Though FIG. 2 illustrates that the synchronizing stage 204 includes two flip-flops (*i.e*., the third and fourth flip-flops 208a and 208b), the scope of the present disclosure is not limited to it. Moreover, the synchronizing stage 204 corresponds to a multi-stage synchronizing circuit. In the present embodiment, the functional signal FS is extended by the sequential logic circuit 202 to output the logic signal LS. Further, the logic signal LS is delayed by the synchronizing stage 204 to output the synchronized functional signal SFS such that the synchronized functional signal SFS is synchronous with the second clock signal CLK2. As a result, the synchronized functional signal SFS that corresponds to the functional signal FS is captured by the second functional circuit 110.

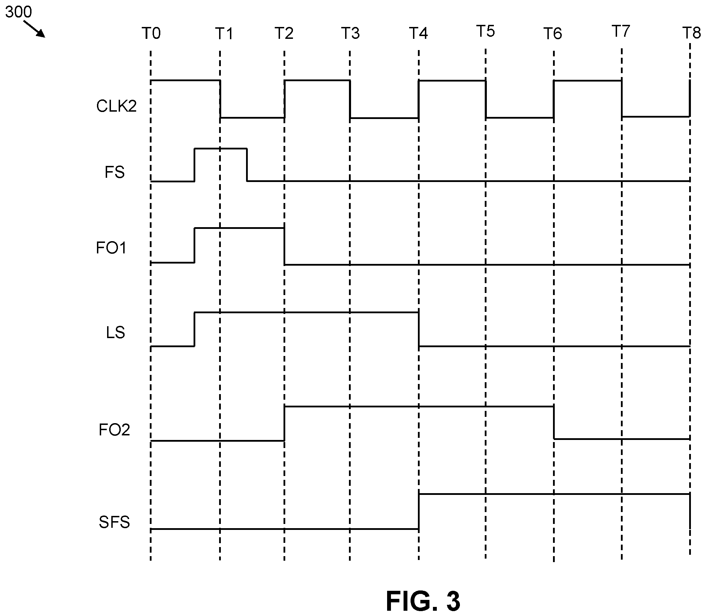

FIG. 3 represents a timing diagram 300 that illustrates an operation of the synchronizer circuit 106 in accordance with an embodiment of the present disclosure. The sequential logic circuit 202 may receive the functional signal FS, output the first flop output signal FO1, and output the logic signal LS. The synchronizing stage 204 may receive the logic signal LS, output the second flop output signal FO2, and output the synchronized functional signal SFS.

During time period T0-T1, the second clock signal CLK2 having the second frequency, is at a logic high state. Moreover, the functional signal FS, associated with the first clock signal CLK1, transitions from a logic low state to a logic high state. As the first clock signal CLK1 has the first frequency, the transition of the functional signal FS does not coincide with the second clock signal CLK2. The first flop output signal FO1 and the logic signal LS also transition from a logic low state to a logic high state, as the functional signal FS transitions from a logic low state to a logic high state. Further, the functional signal FS remains at a logic high state. As the functional signal FS is at a logic high state, the first flop output signal FO1 and the logic signal LS are at a logic high state. As the second flop output signal FO2 is a delayed version of the logic signal LS, the second flop output signal FO2 remains at a previous logic state (*i.e*., a logic low state). Further, as the second flop output signal FO2 is at a logic low state, the synchronized functional signal SFS is at a logic low state.

At time instance T1, the second clock signal CLK2 transitions from a logic high state to a logic low state whereas the functional signal FS, the first flop output signal FO1, and the logic signal LS remain at a logic high state. Further, the logic states of the second flop output signal FO2 and the synchronized functional signal SFS are retained (*i.e.*, the second flop output signal FO2 and the synchronized functional signal SFS remain at a logic low state).

During time period T1-T2, the second clock signal CLK2 remains at a logic low state. The functional signal FS transitions from a logic high state to a logic low state. Further, when the functional signal FS transitions from a logic high state to a logic low state, the first flop output signal FO1 and the logic signal LS remain at a logic high state until the second clock signal CLK2 transitions from one logic state, *i.e.,* a logic low state, to another logic state, *i.e*., a logic high state. Moreover, the second flop output signal FO2 and the synchronized functional signal SFS remain at a logic low state.

At time instance T2, the second clock signal CLK2 transitions from a logic low state to a logic high state, and the functional signal FS remains at a logic low state. Further, as the functional signal FS is at a logic low state, based on the first reference signal R1, the first flop output signal FO1 transitions from a logic high state to a logic low state. Moreover, the first flop output signal FO1 transitions from the logic high state to the logic low state when the second clock signal CLK2 transitions from a logic low state to a logic high state (*i.e*., at a rising edge of the second clock signal CLK2). However, the scope of the present disclosure is not limited to it. In various other embodiments, the first flop output signal FO1 may transition from the logic low state to the logic high state when the second clock signal CLK2 transitions from a logic high state to a logic low state (*i.e*., at a falling edge of the second clock signal CLK2).

Further, as the first flop output signal FO1 transitions from the logic high state to the logic low state at time instance T2, the logic signal LS remains at a logic high state. Based on the logic signal LS, the second flop output signal FO2 transitions from a logic low state to a logic high state when the second clock signal CLK2 transitions from a logic low state to a logic high state. As a result, the logic state of the synchronized functional signal SFS is retained *(i.e*., the synchronized functional signal SFS remains at a logic low state).

During time period T2-T3, the second clock signal CLK2 remains at a logic high state, and the functional signal FS and the first flop output signal FO1 remain at a logic low state. Further, the logic states of the logic signal LS, the second flop output signal FO2, and the synchronized functional signal SFS are retained. In other words, the logic signal LS remains at a logic high state, the second flop output signal FO2 remains at a logic high state, and the synchronized functional signal SFS remains at a logic low state.

At time instance T3, the second clock signal CLK2 transitions from a logic high state to a logic low state. The functional signal FS and the first flop output signal FO1 remain at a logic low state. The logic signal LS and the second flop output signal FO2 remain at a logic high state. Further, the logic state of the synchronized functional signal SFS is retained *(i.e*., the synchronized functional signal SFS remains at a logic low state).

During time period T3-T4, the second clock signal CLK2, the functional signal FS, the first flop output signal FO1, and the synchronized functional signal SFS remain at a logic low state. Further, the logic signal LS and the second flop output signal FO2 remain at a logic high state.

At time instance T4, the second clock signal CLK2 transitions from a logic low state to a logic high state. The functional signal FS and the first flop output signal FO1 remain at a logic low state. As the second clock signal CLK2 transitions from a logic low state to a logic high state, therefore, based on the first flop output signal FO1, the logic signal LS transitions from a logic high state to a logic low state. As a result, the logic state of the second flop output signal FO2 is retained (*i.e*., the second flop output signal FO2 remains at a logic high state). As the second clock signal CLK2 transitions from a logic low state to a logic high state *(i.e*., a subsequent rising edge occurs), due to the logic high state of the second flop output signal FO2, the synchronized functional signal SFS transitions from a logic low state to a logic high state. The logic signal LS is therefore an extended version of the functional signal FS. Further, the time instance when the functional signal FS transitions from a logic high state to a logic low state to the time instance T4 corresponds to the predetermined time duration for which the logic signal LS remains activated after the deactivation of the functional signal FS.

During time period T4-T5, the second clock signal CLK2, the second flop output signal FO2, and the synchronized functional signal SFS remain at a logic high state. Further, the functional signal FS, the first flop output signal FO1, and the logic signal LS remain at a logic low state.

At time instance T5, the second clock signal CLK2 transitions from a logic high state to a logic low state. The functional signal FS, the first flop output signal FO1, and the logic signal LS remain at a logic low state. Further, the logic states of the second flop output signal FO2 and the synchronized functional signal SFS are retained *(i.e*., the second flop output signal FO2 and the synchronized functional signal SFS remain at a logic high state).

During time period T5-T6, the second clock signal CLK2 and the functional signal FS, the first flop output signal FO1, and the logic signal LS remain at a logic low state. The second flop output signal FO2 and the synchronized functional signal SFS remain at a logic high state.

At time instance T6, the second clock signal CLK2 transitions from a logic low state to a logic high state. The functional signal FS, the first flop output signal FO1, and the logic signal LS remain at a logic low state. Further, based on the logic signal LS, the second flop output signal FO2 transitions from a logic high state to a logic low state. As a result, the logic state of the synchronized functional signal SFS is retained (i.e., the synchronized functional signal SFS remains at a logic high state).

During time period T6-T7, the second clock signal CLK2 and the synchronized functional signal SFS remain at a logic high state. The functional signal FS, the first flop output signal FO1, the logic signal LS, and the second flop output signal FO2 remain at a logic low state.

At time instance T7, the second clock signal CLK2 transitions from a logic high state to a logic low state. The functional signal FS, the first flop output signal FO1, the logic signal LS, and the second flop output signal FO2 remain at a logic low state. Moreover, the logic state of the synchronized functional signal SFS is retained (i.e., the synchronized functional signal SFS remains at a logic high state).

During time period T7-T8, the second clock signal CLK2 and the functional signal FS, the first flop output signal FO1, the logic signal LS, and the second flop output signal FO2 remain at a logic low state. Further, the synchronized functional signal SFS remains at a logic high state.

At time instance T8, the second clock signal CLK2 transitions from a logic low state to a logic high state. The functional signal FS, the first flop output signal FO1, the logic signal LS, and the second flop output signal FO2 remain at a logic low state. As the second clock signal CLK2 transitions from a logic low state to a logic high state and the second flop output signal FO2 is at the logic low state, the synchronized functional signal SFS transitions from a logic high state to a logic low state. Therefore, the synchronized functional signal SFS is at a logic high state during the time period T4-T8. As a result, the synchronized functional signal SFS is a delayed and extended version of the functional signal FS. Time period T1-T4, thus, corresponds to the delay of the logic signal LS, provided by the synchronizing stage 204.

The transitions of various signals illustrated in FIG. 3 (such as the functional signal FS, the first flop output signal FO1, the logic signal LS, the second flop output signal FO2, and the synchronized functional signal SFS) are sans set up time associated with each signal to make the illustrations concise and clear and should not be considered as a limitation of the present disclosure.

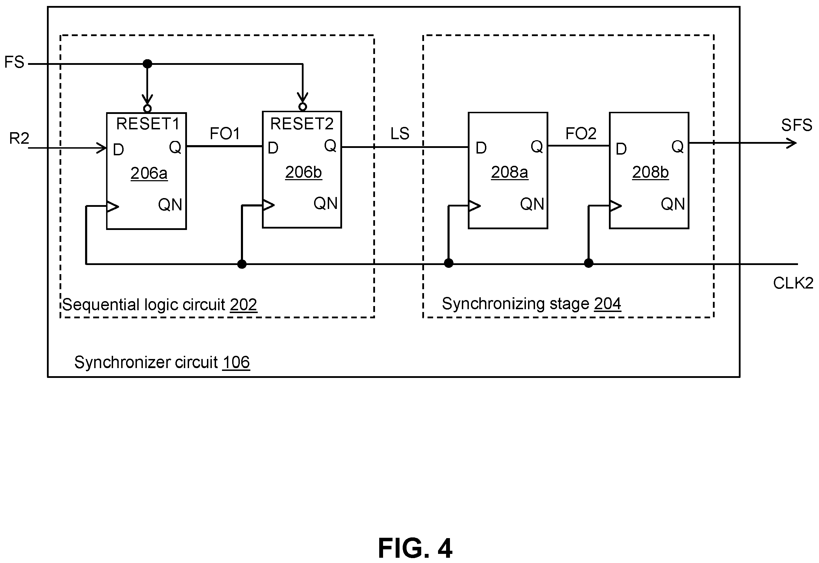

FIG. 4 illustrates a schematic circuit diagram of the synchronizer circuit 106 in accordance with another embodiment of the present disclosure. The synchronizer circuit 106 may include the sequential logic circuit 202 and the synchronizing stage 204. The sequential logic circuit 202 may include the first flip-flop 206a and the second flip-flop 206b. In the present embodiment, the second functional circuit 110 may be an active-low circuit (*i.e*., the second functional circuit 110 is operational on the reception of the synchronized functional signal SFS at a logic low state).

The functionalities of the sequential logic circuit 202 and the synchronizing stage 204 remain the same as described in FIG. 2. The difference between the synchronizer circuit 106 of FIG. 2 and the synchronizer circuit 106 of FIG. 4 is that the first and second control terminals of the first flip-flop 206a and the second flip-flop 206b of the synchronizer circuit 106 of FIG. 4 are reset terminals (shown as RESET1 and RESET2, respectively). Moreover, the synchronizer circuit 106 (*i.e*., the first input terminal of the first flip-flop 206a) may be coupled to the second reference signal generator 114. Thus, the first input terminal of the first flip-flop 206a is configured to receive the second reference signal R2 at a logic high state. In the present embodiment, the functional signal FS and the logic signal LS are activated when the functional signal FS and the logic signal LS are at a logic low state and deactivated when the functional signal FS and the logic signal LS are at a logic high state. As a result, when the functional signal FS is activated (*i.e*., at a logic low state), the logic signal LS is activated (*i.e*., at a logic low state) and remains activated for the predetermined time duration after the deactivation of the functional signal FS (*i.e*., at a logic high state).

When the functional signal FS subsequently transitions from the logic low state to the logic high state, the first flop output signal FO1 remains at the logic low state until the second clock signal CLK2 transitions from one logic state, *i.e*., a logic low state, to another logic state, *i.e*., a logic high state. Further, when the first flop output signal FO1 subsequently transitions from the logic low state to a logic high state, the logic signal LS remains at the logic low state until the second clock signal CLK2 transitions from a logic low state to a logic high state.

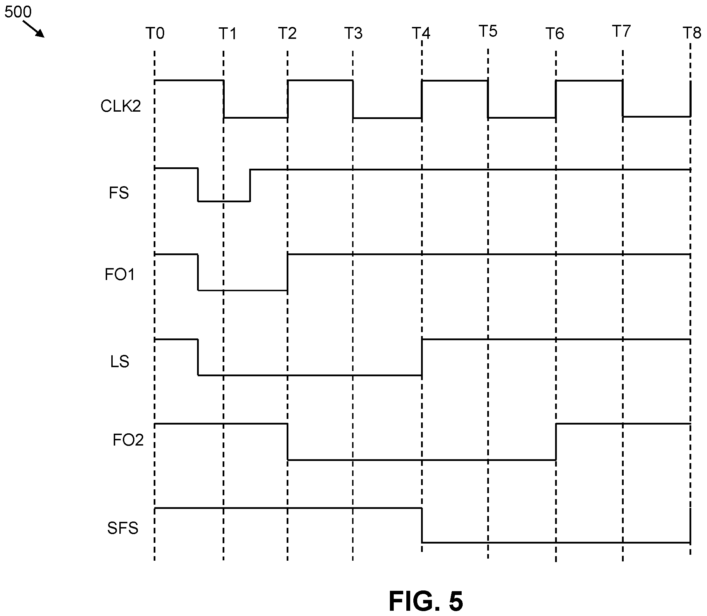

FIG. 5 represents a timing diagram 500 that illustrates an operation of the synchronizer circuit 106 in accordance with another embodiment of the present disclosure. The sequential logic circuit 202 may receive the functional signal FS, output the first flop output signal FO1, and output the logic signal LS. The synchronizing stage 204 may receive the logic signal LS, output the second flop output signal FO2, and output the synchronized functional signal SFS.

During time period T0-T1, the second clock signal CLK2 having the second frequency, is at a logic high state. Moreover, the functional signal FS, associated with the first clock signal CLK1, transitions from a logic high state to a logic low state. As the first clock signal CLK1 has the first frequency, the transition of the functional signal FS does not coincide with the second clock signal CLK2. As the functional signal FS transitions to a logic low state, the first flop output signal FO1 and the logic signal LS transition from a logic high state to a logic low state. As the second flop output signal FO2 is a delayed version of the logic signal LS, the second flop output signal FO2 remains at a previous logic state (*i.e*., at a logic high state). Further, as the second flop output signal FO2 is at a logic high state, the synchronized functional signal SFS is at a logic high state.

At time instance T1, the second clock signal CLK2 transitions from a logic high state to a logic low state. The functional signal FS, the first flop output signal FO1, and the logic signal LS remain at a logic low state. Further, the logic states of the second flop output signal FO2 and the synchronized functional signal SFS are retained (*i.e*., the second flop output signal FO2 and the synchronized functional signal SFS remain at a logic high state).

During time period T1-T2, the second clock signal CLK2 remains at a logic low state. The functional signal FS transitions from a logic low state to a logic high state. Further, when the functional signal FS transitions from a logic low state to a logic high state, the first flop output signal FO1 and the logic signal LS remain at a logic low state until the second clock signal CLK2 transitions from a logic low state to a logic high state. Moreover, the second flop output signal FO2 and the synchronized functional signal SFS remain at a logic high state.

At time instance T2, the second clock signal CLK2 transitions from a logic low state to a logic high state, and the functional signal FS remains at a logic high state. Further, as the functional signal FS is at a logic high state, the first flop output signal FO1, based on the second reference signal R2, transitions from a logic low state to a logic high state. Moreover, the first flop output signal FO1 transitions from the logic low state to the logic high state when the second clock signal CLK2 transitions from a logic low state to a logic high state (*i.e*., at a rising edge of the second clock signal CLK2). As a result, the logic signal LS remains at a logic low state. Based on the logic signal LS, the second flop output signal FO2 transitions from a logic high state to a logic low state when the second clock signal CLK2 transitions from a logic low state to a logic high state. Hence, the logic state of the synchronized functional signal SFS is retained (*i.e*., the synchronized functional signal SFS remains at a logic high state). Further, the synchronized functional signal SFS is the delayed version of the second flop output signal FO2. The synchronized functional signal SFS is thus at a logic high state.

During time period T2-T3, the second clock signal CLK2 remains at a logic high state, and the functional signal FS and the first flop output signal FO1 remain at a logic high state. Further, the logic state of the logic signal LS, the second flop output signal FO2, and the synchronized functional signal SFS are retained (*i.e*., the logic signal LS remains at a logic low state, the second flop output signal FO2 remains at a logic low state, and the synchronized functional signal SFS remains at a logic high state).

At time instance T3, the second clock signal CLK2 transitions from a logic high state to a logic low state. The functional signal FS and the first flop output signal FO1 remain at a logic high state. The logic signal LS and the second flop output signal FO2 remain at a logic low state. Further, the logic state of the synchronized functional signal SFS is retained (*i.e*., the synchronized functional signal SFS remains at a logic high state).

During time period T3-T4, the second clock signal CLK2 remains at a logic low state. Further, the functional signal FS, the first flop output signal FO1, and the synchronized functional signal SFS remain at a logic high state. Further, the logic signal LS and the second flop output signal FO2 remain at a logic low state.

At time instance T4, the second clock signal CLK2 transitions from a logic low state to a logic high state. The functional signal FS and the first flop output signal FO1 remain at a logic high state. As the second clock signal CLK2 transitions from a logic low state to a logic high state, therefore, based on the first flop output signal FO1, the logic signal LS transitions from a logic low state to a logic high state. As a result, the logic state of the second flop output signal FO2 is retained (*i.e*., the second flop output signal FO2 remains at a logic low state). The second clock signal CLK2 transitions from a logic low state to a logic high state (*i.e*., a subsequent rising edge occurs). Thus, based on the second flop output signal FO2, the synchronized functional signal SFS transitions from a logic high state to a logic low state. The logic signal LS is therefore an extended version of the functional signal FS. Further, a time instance when the functional signal FS transitions from a logic low state to a logic high state to the time instance T4 corresponds to the predetermined time duration for which the logic signal LS remains activated (*i.e*., at a logic low state) after the deactivation of the functional signal FS.

During time period T4-T5, the second clock signal CLK2 remains at a logic high state, and the second flop output signal FO2 and the synchronized functional signal SFS remain at a logic low state. Further, the functional signal FS, the first flop output signal FO1, and the logic signal LS remain at a logic high state.

At time instance T5, the second clock signal CLK2 transitions from a logic high state to a logic low state. The functional signal FS, the first flop output signal FO1, and the logic signal LS remain at a logic high state. Further, the logic state of the second flop output signal FO2 and the synchronized functional signal SFS are retained (*i.e*., the second flop output signal FO2 and the synchronized functional signal SFS remain at a logic low state).

During time period T5-T6, the second clock signal CLK2 remains at a logic low state, and the functional signal FS, the first flop output signal FO1, and the logic signal LS remain at a logic high state. Further, the second flop output signal FO2 and the synchronized functional signal SFS remain at a logic low state.

At time instance T6, the second clock signal CLK2 transitions from a logic low state to a logic high state. The functional signal FS, the first flop output signal FO1, and the logic signal LS remain at a logic high state. Further, based on the transition of the second clock signal CLK2 from a logic low state to a logic high state, the second flop output signal FO2 transitions from a logic low state to a logic high state. As a result, the logic state of the synchronized functional signal SFS is retained (*i.e*., the synchronized functional signal SFS remains at a logic low state).

During time period T6-T7, the second clock signal CLK2 remains at a logic high state and the synchronized functional signal SFS remains at a logic low state. Further, the functional signal FS, the first flop output signal FO1, the logic signal LS, and the second flop output signal FO2 remain at a logic high state.

At time instance T7, the second clock signal CLK2 transitions from a logic high state to a logic low state. The functional signal FS, the first flop output signal FO1, the logic signal LS, and the second flop output signal FO2 remain at a logic high state. Moreover, the logic state of the synchronized functional signal SFS is retained (*i.e*., the synchronized functional signal SFS remains at a logic low state).

During time period T7-T8, the second clock signal CLK2 remains at a logic low state, and the functional signal FS, the first flop output signal FO1, the logic signal LS, and the second flop output signal FO2 remain at a logic high state. Further, the synchronized functional signal SFS remains at a logic low state.

At time instance T8, the second clock signal CLK2 transitions from a logic low state to a logic high state. The functional signal FS, the first flop output signal FO1, the logic signal LS, and the second flop output signal FO2 remain at a logic high state. As the second clock signal CLK2 transitions from a logic low state to a logic high state, based on the second flop output signal FO2, the synchronized functional signal SFS transitions from a logic low state to a logic high state. Therefore, the synchronized functional signal SFS is at a logic low state during the time period T4-T8. As a result, the synchronized functional signal SFS is a delayed and extended version of the functional signal FS. Time period T1-T4, thus, corresponds to the delay of the logic signal LS provided by the synchronizing stage 204.

The transitions of various signals illustrated in FIG. 5 (such as the functional signal FS, the first flop output signal FO1, the logic signal LS, the second flop output signal FO2, and the synchronized functional signal SFS) are sans set up time associated with each signal to make the illustrations concise and clear and should not be considered as a limitation of the present disclosure.

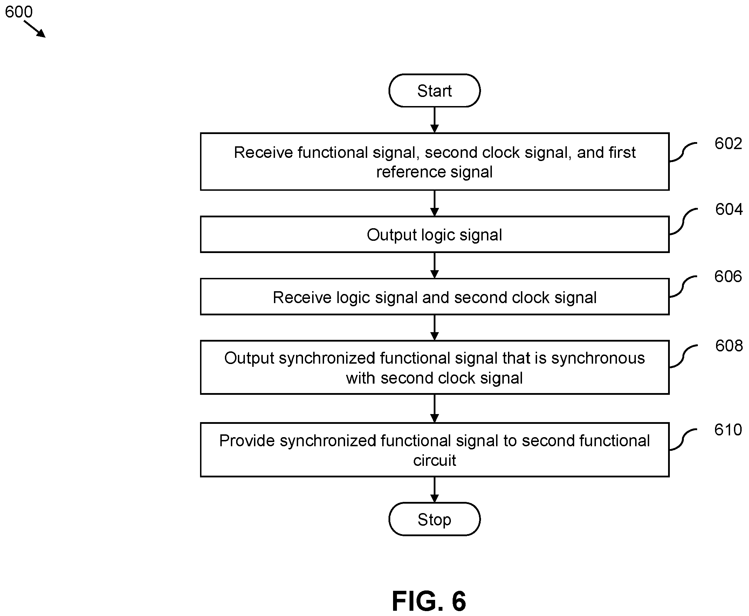

FIG. 6 represents a flowchart 600 that illustrates a synchronization method for the multi-clock domain system 100 in accordance with an embodiment of the present disclosure. The synchronization method corresponds to synchronizing the functional signal FS with respect to the second clock signal CLK2. The synchronization method is performed by the synchronizer circuit 106.

At step 602, the sequential logic circuit 202 may receive the functional signal FS, the second clock signal CLK2, and the first reference signal R1 from the first functional circuit 104, the second clock generator 108, and the first reference signal generator 112, respectively. The first reference signal R1 is received at the logic low state. At step 604, the sequential logic circuit 202 may output the logic signal LS based on the functional signal FS, the second clock signal CLK2, and the first reference signal R1. The logic signal LS is outputted such that the logic signal LS is at the logic high state when the functional signal FS is at the logic high state. Further, the logic signal LS remains at the logic high state for the predetermined time duration after the functional signal FS transitions from the logic high state to the logic low state. The predetermined time duration is determined based on the second clock signal CLK2. After the lapse of the predetermined time duration, the logic signal LS transitions from the logic high state to the logic low state based on the first reference signal R1.

At step 606, the synchronizing stage 204 may receive the logic signal LS and the second clock signal CLK2 from the sequential logic circuit 202 and the second clock generator 108, respectively. At step 608, the synchronizing stage 204 may output the synchronized functional signal SFS that is synchronous with the second clock signal CLK2. The synchronized functional signal SFS is the delayed version of the logic signal LS. The delay between the synchronized functional signal SFS and the logic signal LS is greater than one clock cycle of the second clock signal CLK2. At step 610, the synchronizing stage 204 may provide the synchronized functional signal SFS to the second functional circuit 110.

The flowchart 600 illustrates the synchronization method for active-high functional circuits. The synchronization method for active-low functional circuits may be similar to the flowchart 600 with the first reference signal R1 being replaced by the second reference signal R2. In such a scenario, the logic signal LS is outputted such that the logic signal LS is at the logic low state when the functional signal FS is at the logic low state. Further, the logic signal LS remains at the logic low state for the predetermined time duration after the functional signal FS transitions from the logic low state to the logic high state.

Conventional synchronizer circuits fail to capture a functional signal when the functional signal is a pulse signal. Further, the conventional synchronizer circuits are unable to capture the functional signal when a frequency of a clock signal associated with a transmitting functional circuit that transmits the functional signal or a clock signal associated with a receiving functional circuit that receives the functional signal is changed. Thus, operational errors occur in the circuitry that is coupled with the conventional synchronizer circuit. To reduce such operational errors, conventional synchronizer circuits may include complex circuitry to capture such pulse signals that further lead to design complexity of the synchronizer circuits.

The synchronizer circuit 106 of the present disclosure is able to capture pulse signals by extending and delaying the pulse signal, *i.e*., the functional signal FS, to synchronize the functional signal FS with the second clock signal CLK2. Thus, the synchronizer circuit 106 is able to capture the functional signal FS in an event when the frequency of the first clock signal CLK1 or the second clock signal CLK2 is changed. Since, the synchronizer circuit 106 receives a single clock signal (*i.e*., the second clock signal CLK2), the synchronized functional signal SFS is independent of a ratio of frequencies (*i.e.*, the first and second frequencies) associated with the first clock signal CLK1 and the second clock signal CLK2. The extended signal (*i.e*., the logic signal LS) is delayed to output the second flop output signal FO2, and the second flop output signal FO2 is further delayed to output the synchronized functional signal SFS. In addition, the synchronizer circuit 106 synchronizes the functional signal FS with the second clock signal CLK2 without any requirement of a feedback signal to indicate the first functional circuit 104 that the functional signal FS is captured by the second functional circuit 110. Thus, additional feedback circuitry is not required to generate, synchronize, and route the feedback signal by the second clock domain (*i.e*., the second functional circuit 110) to the first clock domain (*i.e*., the first functional circuit 104). Therefore, the design complexity, size, and manufacturing cost of the synchronizer circuit 106 are reduced as compared to conventional synchronizer circuits.

A multi-clock domain system includes a synchronizer circuit. The synchronizer circuit includes a sequential logic circuit and a synchronizing stage. The sequential logic circuit receives a functional signal that is generated based on a first clock signal that is further associated with a first clock domain, a second clock signal that is associated with a second clock domain, and a reference signal. Based on the first and second clock signals and the reference signal, the synchronizer circuit outputs a logic signal. When the functional signal is activated, the logic signal is activated and remains activated for a predetermined time duration after the functional signal is deactivated. The synchronizing stage receives the second clock signal and further receives the logic signal from the sequential logic circuit, and outputs a synchronized functional signal.

While various embodiments of the present disclosure have been illustrated and described, it will be clear that the present disclosure is not limited to these embodiments only. Numerous modifications, changes, variations, substitutions, and equivalents will be apparent to those skilled in the art, without departing from the scope of the appended claims.

## Claims

1. A multi-clock domain system comprising:
a synchronizer circuit (106) comprising:
a sequential logic circuit (202) configured to receive (i) a functional signal that is generated based on a first clock signal, (ii) a second clock signal, and (iii) a reference signal, and output a logic signal, wherein the first clock signal and the second clock signal are associated with a first clock domain and a second clock domain, respectively, wherein the logic signal is an extended version of the functional signal such that the logic signal is set to a logic state in response to the functional signal being set to a logic state, and remains at the logic state for a predetermined time duration after the functional signal transitions to another logic state, and wherein the predetermined time duration is determined based on the second clock signal; and
a synchronizing stage (204) that is coupled to the sequential logic circuit (202), and configured to receive the logic signal and the second clock signal and output a synchronized functional signal that is synchronous with the second clock signal;
wherein the sequential logic circuit (202) comprises a first flip-flop (206a) and a second flip-flop (206b) that are coupled in series, wherein the first flip-flop (206a) has (i) a first input terminal configured to receive the reference signal, (ii) a first control terminal configured to receive the functional signal, (iii) a first clock terminal configured to receive the second clock signal, and (iv) a first output terminal configured to output a first flop output signal, and wherein the second flip-flop (206b) has (i) a second input terminal configured to receive the first flop output signal, (ii) a second control terminal configured to receive the functional signal, (iii) a second clock terminal configured to receive the second clock signal, and (iv) a second output terminal configured to output the logic signal; and
wherein the synchronizing stage (204) comprises:
a third flip-flop (208a) that has (i) a third input terminal configured to receive the logic signal, (ii) a third clock terminal configured to receive the second clock signal, and (iii) a third output terminal configured to output a second flop output signal, wherein the second flop output signal is a delayed version of the logic signal; and
a fourth flip-flop (208b) that has (i) a fourth input terminal configured to receive the second flop output signal, (ii) a fourth clock terminal configured to receive the second clock signal, and (iii) a fourth output terminal configured to output the synchronized functional signal, wherein the synchronized functional signal is a delayed version of the second flop output signal, and wherein the second flop output signal is delayed by one clock cycle of the second clock signal to output the synchronized functional signal.

2. The multi-clock domain system of claim 1, wherein the first control terminal and the second control terminal of the first flip-flop and the second flip-flop are set terminals that receive the functional signal, respectively, wherein the reference signal is received at a logic low state, and wherein the logic state that the functional signal and the logic signal are set to corresponds to a logic high state and the logic state that the functional signal transitions to corresponds to a logic low state.

3. The multi-clock domain system of claim 2, further comprising a first reference signal generator that is configured to be coupled to the sequential logic circuit, and generate and provide the reference signal at the logic low state to the sequential logic circuit.

4. The multi-clock domain system of any of claims 2 or 3, wherein when the functional signal is at the logic high state, the first flop output signal is at a logic high state, and wherein when the functional signal subsequently transitions from the logic high state to the logic low state, the first flop output signal remains at the logic high state until the second clock signal transitions from one logic state to another logic state.

5. The multi-clock domain system of claim 4, wherein when the functional signal is at the logic high state, the logic signal is at the logic high state, wherein when the functional signal subsequently transitions from the logic high state to the logic low state, the logic signal remains at the logic high state as the first flop output signal is at the logic high state, and wherein when the first flop output signal subsequently transitions from the logic high state to a logic low state, the logic signal remains at the logic high state until the second clock signal transitions from one logic state to another logic state.

6. The multi-clock domain system of any of claims 1 to 5, wherein the first control terminal and the second control terminal of the first flip-flop and the second flip-flop are reset terminals that receive the functional signal, respectively, wherein the reference signal is received at a logic high state, and wherein the logic state that the functional signal and the logic signal are set to corresponds to a logic low state and the logic state that the functional signal transitions to corresponds to a logic high state.

7. The multi-clock domain system of claim 6, further comprising a second reference signal generator that is configured to be coupled to the sequential logic circuit and generate and provide the reference signal at the logic high state to the sequential logic circuit.

8. The multi-clock domain system of any of claims 6 or 7, wherein when the functional signal is at the logic low state, the first flop output signal is at a logic low state, and wherein when the functional signal subsequently transitions from the logic low state to the logic high state, the first flop output signal remains at the logic low state until the second clock signal transitions from one logic state to another logic state.

9. The multi-clock domain system of claim 8, wherein when the functional signal is at the logic low state, the logic signal is at the logic low state, wherein when the functional signal subsequently transitions from the logic low state to the logic high state, the logic signal remains at the logic low state as the first flop output signal is at the logic low state, and wherein when the first flop output signal subsequently transitions from the logic low state to a logic high state, the logic signal remains at the logic low state until the second clock signal transitions from one logic state to another logic state.

10. The multi-clock domain system of any preceding claim, wherein the predetermined time duration is greater than one clock cycle of the second clock signal.

11. The multi-clock domain system of any preceding claim, wherein the synchronized functional signal is a delayed version of the logic signal, and wherein a delay between the synchronized functional signal and the logic signal is greater than one clock cycle of the second clock signal.

12. The multi-clock domain system of any preceding claim, further comprising a first functional circuit associated with the first clock domain, coupled to the sequential logic circuit, and configured to generate and provide the functional signal to the sequential logic circuit.

13. A synchronization method for a multi-clock domain system, the synchronization method comprising:
receiving, by a sequential logic circuit (202) of a synchronizer circuit (106), (i) a functional signal that is generated based on a first clock signal, (ii) a second clock signal, and (iii) a reference signal, wherein the first clock signal and the second clock signal are associated with a first clock domain and a second clock domain, respectively, wherein the sequential logic circuit (202) comprises a first flip-flop (206a) and a second flip-flop (206b) that are coupled in series, wherein the first flip-flop (206a) has (i) a first input terminal that receives the reference signal, (ii) a first control terminal that receives the functional signal, (iii) a first clock terminal that receives the second clock signal, and (iv) a first output terminal that outputs a first flop output signal, and wherein the second flip-flop (206b) has (i) a second input terminal that receives the first flop output signal, (ii) a second control terminal that receives the functional signal, (iii) a second clock terminal that receives the second clock signal, and (iv) a second output terminal that outputs the logic signal;
outputting, by the sequential logic circuit (202), a logic signal based on the functional signal, the second clock signal, and the reference signal, wherein the logic signal is an extended version of the functional signal such that the logic signal is set to a logic state in response to the functional signal being set to a logic state and remains at the logic state for a predetermined time duration after the functional signal transitions to another logic state, and wherein the predetermined time duration is determined based on the second clock signal;
receiving, by a synchronizing stage (204) of the synchronizer circuit (106), the logic signal and the second clock signal; and
outputting, by the synchronizing stage (204), based on the logic signal and the second clock signal, a synchronized functional signal that is synchronous with the second clock signal, wherein the synchronizing stage (204) comprises:
a third flip-flop (208a) that has (i) a third input terminal that receives the logic signal, (ii) a third clock terminal that receives the second clock signal, and (iii) a third output terminal that outputs a second flop output signal, wherein the second flop output signal is a delayed version of the logic signal; and
a fourth flip-flop (208b) that has (i) a fourth input terminal that receives the second flop output signal, (ii) a fourth clock terminal that receives the second clock signal, and (iii) a fourth output terminal that outputs the synchronized functional signal, wherein the synchronized functional signal is a delayed version of the second flop output signal, and wherein the second flop output signal is delayed by one clock cycle of the second clock signal to output the synchronized functional signal.

## Patentansprüche

1. System mit mehreren Taktbereichen, das Folgendes umfasst:
eine Synchronisatorschaltung (106), die Folgendes umfasst:
eine sequentielle Logikschaltung (202), die konfiguriert ist, (i) ein Funktionssignal, das basierend auf einem ersten Taktsignal erzeugt wird, (ii) ein zweites Taktsignal und (iii) ein Referenzsignal zu empfangen und ein Logiksignal auszugeben, wobei das erste Taktsignal und das zweite Taktsignal einem ersten Taktbereich bzw. einem zweiten Taktbereich zugeordnet sind, wobei das Logiksignal eine erweiterte Version des Funktionssignals ist, so dass das Logiksignal in Reaktion darauf, dass das Funktionssignal in einen Logikzustand gesetzt wird, in einen Logikzustand gesetzt wird und während einer vorgegebenen Zeitdauer in dem Logikzustand bleibt, nachdem das Funktionssignal in einen weiteren Logikzustand übergegangen ist, und wobei die vorgegebene Zeitdauer basierend auf dem zweiten Taktsignal bestimmt wird; und
eine Synchronisationsstufe (204), die an die sequentielle Logikschaltung (202) gekoppelt ist und konfiguriert ist, das Logiksignal und das zweite Taktsignal zu empfangen und ein synchronisiertes Funktionssignal auszugeben, das mit dem zweiten Taktsignal synchron ist;
wobei die sequentielle Logikschaltung (202) ein erstes Flipflop (206a) und ein zweites Flipflop (206b) umfasst, die in Reihe geschaltet sind, wobei das erste Flipflop (206a) (i) einen ersten Eingangsanschluss, der konfiguriert ist, das Referenzsignal zu empfangen, (ii) einen ersten Steueranschluss, der konfiguriert ist, das Funktionssignal zu empfangen, (iii) einen ersten Taktanschluss, der konfiguriert ist, das zweite Taktsignal zu empfangen, und (iv) einen ersten Ausgangsanschluss, der konfiguriert ist, ein erstes Flop-Ausgangssignal auszugeben, aufweist, und wobei das zweite Flipflop (206b) einen zweiten Eingangsanschluss, der konfiguriert ist, das erste Flop-Ausgangssignal zu empfangen, (ii) einen zweiten Steueranschluss, der konfiguriert ist, das Funktionssignal zu empfangen, (iii) einen zweiten Taktanschluss, der konfiguriert ist, das zweite Taktsignal zu empfangen, und (iv) einen zweiten Ausgangsanschluss, der konfiguriert ist, das Logiksignal auszugeben, aufweist; und
wobei die Synchronisationsstufe (204) Folgendes umfasst:
ein drittes Flipflop (208a), das einen dritten Eingangsanschluss, der konfiguriert ist, das Logiksignal zu empfangen, (ii) einen dritten Taktanschluss, der konfiguriert ist, das zweite Taktsignal zu empfangen, und (iii) einen dritten Ausgangsanschluss, der konfiguriert ist, ein zweites Flop-Ausgangssignal auszugeben, aufweist, wobei das zweite Flop-Ausgangssignal eine verzögerte Version des Logiksignals ist; und
ein viertes Flipflop (208b), das (i) einen vierten Eingangsanschluss, der konfiguriert ist, das zweite Flop-Ausgangssignal zu empfangen, (ii) einen vierten Taktanschluss, der konfiguriert ist, das zweite Taktsignal zu empfangen, und (iii) einen vierten Ausgangsanschluss, der konfiguriert ist, das synchronisierte Funktionssignal auszugeben, aufweist, wobei das synchronisierte Funktionssignal eine verzögerte Version des zweiten Flop-Ausgangssignals ist, und wobei das zweite Flop-Ausgangssignal um einen Taktzyklus des zweiten Taktsignals verzögert wird, um das synchronisierte Funktionssignal auszugeben.

2. System mit mehreren Taktbereichen nach Anspruch 1, wobei der erste Steueranschluss und der zweite Steueranschluss des ersten Flipflops und des zweiten Flipflops Setz-Anschlüsse sind, die jeweils das Funktionssignal empfangen, wobei das Referenzsignal in einem tiefen Logikzustand empfangen wird, und wobei der Logikzustand, in den das Funktionssignal und das Logiksignal gesetzt sind, einem hohen Logikzustand entspricht, und der Logikzustand, in den das Funktionssignal übergeht, einem tiefen Logikzustand entspricht.

3. System mit mehreren Taktbereichen nach Anspruch 2, das ferner einen ersten Referenzsignalgenerator umfasst, der konfiguriert ist, an die sequentielle Logikschaltung gekoppelt zu sein und das Referenzsignal in dem tiefen Logikzustand zu erzeugen und der sequentiellen Logikschaltung bereitzustellen.

4. System mit mehreren Taktbereichen nach einem der Ansprüche 2 oder 3, wobei dann, wenn sich das Funktionssignal in dem hohen Logikzustand befindet, sich das erste Flop-Ausgangssignal in einem hohen Logikzustand befindet, und wobei dann, wenn das Funktionssignal anschließend aus dem hohen Logikzustand in den tiefen Logikzustand übergeht, das erste Flop-Ausgangssignal in dem hohen Logikzustand bleibt, bis das zweite Taktsignal aus einem Logikzustand in einen weiteren Logikzustand übergeht.

5. System mit mehreren Taktbereichen nach Anspruch 4, wobei dann, wenn sich das Funktionssignal in dem hohen Logikzustand befindet, sich das Logiksignal in dem hohen Logikzustand befindet, wobei dann, wenn das Funktionssignal anschließend aus dem hohen Logikzustand in den tiefen Logikzustand übergeht, das Logiksignal in dem hohen Logikzustand bleibt, wenn sich das erste Flop-Ausgangssignal in dem hohen Logikzustand befindet, und wobei dann, wenn das erste Flop-Ausgangssignal anschließend aus dem hohen Logikzustand in einen tiefen Logikzustand übergeht, das Logiksignal in dem hohen Logikzustand bleibt, bis das zweite Taktsignal aus einem Logikzustand in einen weiteren Logikzustand übergeht.

6. System mit mehreren Taktbereichen nach einem der Ansprüche 1 bis 5, wobei der erste Steueranschluss und der zweite Steueranschluss des ersten Flipflops und des zweiten Flipflops Rücksetz-Anschlüsse sind, die jeweils das Funktionssignal empfangen, wobei das Referenzsignal in einem hohen Logikzustand empfangen wird, und wobei der Logikzustand, in den das Funktionssignal und das Logiksignal gesetzt sind, einem tiefen Logikzustand entspricht, und der Logikzustand, in den das Funktionssignal übergeht, einem hohen Logikzustand entspricht.

7. System mit mehreren Taktbereichen nach Anspruch 6, das ferner einen zweiten Referenzsignalgenerator umfasst, der konfiguriert ist, an die sequentielle Logikschaltung gekoppelt zu sein und das Referenzsignal in dem hohen Logikzustand zu erzeugen und der sequentiellen Logikschaltung bereitzustellen.

8. System mit mehreren Taktbereichen nach einem der Ansprüche 6 oder 7, wobei dann, wenn sich das Funktionssignal in dem tiefen Logikzustand befindet, sich das erste Flop-Ausgangssignal in einem tiefen Logikzustand befindet, und wobei dann, wenn das Funktionssignal anschließend aus dem tiefen Logikzustand in den hohen Logikzustand übergeht, das erste Flop-Ausgangssignal in dem tiefen Logikzustand bleibt, bis das zweite Taktsignal aus einem Logikzustand in einen weiteren Logikzustand übergeht.

9. System mit mehreren Taktbereichen nach Anspruch 8, wobei dann, wenn sich das Funktionssignal in dem tiefen Logikzustand befindet, sich das Logiksignal in dem tiefen Logikzustand befindet, wobei dann, wenn das Funktionssignal anschließend aus dem tiefen Logikzustand in den hohen Logikzustand übergeht, das Logiksignal in dem tiefen Logikzustand bleibt, wenn sich das erste Flop-Ausgangssignal in dem tiefen Logikzustand befindet, und wobei dann, wenn das erste Flop-Ausgangssignal anschließend aus dem tiefen Logikzustand in einen hohen Logikzustand übergeht, das Logiksignal in dem tiefen Logikzustand bleibt, bis das zweite Taktsignal aus einem Logikzustand in einen weiteren Logikzustand übergeht.

10. System mit mehreren Taktbereichen nach einem vorhergehenden Anspruch, wobei die vorgegebene Zeitdauer größer als ein Taktzyklus des zweiten Taktsignals ist.

11. System mit mehreren Taktbereichen nach einem vorhergehenden Anspruch, wobei das synchronisierte Funktionssignal eine verzögerte Version des Logiksignals ist, und wobei eine Verzögerung zwischen dem synchronisierten Funktionssignal und dem Logiksignal größer als ein Taktzyklus des zweiten Taktsignals ist.

12. System mit mehreren Taktbereichen nach einem vorhergehenden Anspruch, das ferner eine erste Funktionsschaltung umfasst, die dem ersten Taktbereich zu geordnet ist, an die sequentielle Logikschaltung gekoppelt ist und konfiguriert ist, das Funktionssignal zu erzeugen und der sequentiellen Logikschaltung bereitzustellen.

13. Synchronisationsverfahren für ein System mit mehreren Taktbereichen, wobei das Synchronisationsverfahren Folgendes umfasst:
Empfangen durch eine sequentielle Logikschaltung (202) einer Synchronisatorschaltung (106) (i) eines Funktionssignals, das basierend auf einem ersten Taktsignal erzeugt wird, (ii) eines zweiten Taktsignals und (iii) eines Referenzsignals, wobei das erste Taktsignal und das zweite Taktsignal einem ersten Taktbereich bzw. einem zweiten Taktbereich zugeordnet sind, wobei die sequentielle Logikschaltung (202) ein erstes Flipflop (206a) und ein zweites Flipflop (206b) umfasst, die in Reihe geschaltet sind, wobei das erste Flipflop (206a) (i) einen ersten Eingangsanschluss, der das Referenzsignal empfängt, (ii) einen ersten Steueranschluss, der das Funktionssignal empfängt, (iii) einen ersten Taktanschluss, der das zweite Taktsignal empfängt, und (iv) einen ersten Ausgangsanschluss, der das erste Flop-Ausgangssignal ausgibt, aufweist, und wobei das zweite Flipflop (206b) einen zweiten Eingangsanschluss, der das erste Flop-Ausgangssignal empfängt, (ii) einen zweiten Steueranschluss, der das Funktionssignal empfängt, (iii) einen zweiten Taktanschluss, der das zweite Taktsignal empfängt, und (iv) einen zweiten Ausgangsanschluss, der das Logiksignal ausgibt, aufweist;
Ausgeben durch eine sequentielle Logikschaltung (202) eines Logiksignals basierend auf dem Funktionssignal, dem zweiten Taktsignal und dem Referenzsignal, wobei das Logiksignal eine erweiterte Version des Funktionssignals ist, so dass das Logiksignal in Reaktion darauf, dass das Funktionssignal in einen Logikzustand gesetzt wird, in einen Logikzustand gesetzt wird und während einer vorgegebenen Zeitdauer in dem Logikzustand bleibt, nachdem das Funktionssignal in einen weiteren Logikzustand übergegangen ist, und wobei die vorgegebene Zeitdauer basierend auf dem zweiten Taktsignal bestimmt wird;
Empfangen durch eine Synchronisationsstufe (204) der Synchronisatorschaltung (106) des Logiksignals und des zweiten Taktsignals; und
Ausgeben durch die Synchronisationsstufe (204) basierend auf dem Logiksignal und dem zweiten Taktsignal eines synchronisierten Funktionssignals, das mit dem zweiten Taktsignal synchron ist; wobei die Synchronisationsstufe (204) Folgendes umfasst:
ein drittes Flipflop (208a), das einen dritten Eingangsanschluss, der das Logiksignal empfängt, (ii) einen dritten Taktanschluss, der das zweite Taktsignal empfängt, und (iii) einen dritten Ausgangsanschluss, der ein zweites Flop-Ausgangssignal ausgibt, aufweist, wobei das zweite Flop-Ausgangssignal eine verzögerte Version des Logiksignals ist; und
ein viertes Flipflop (208b), das (i) einen vierten Eingangsanschluss, der das zweite Flop-Ausgangssignal empfängt, (ii) einen vierten Taktanschluss, der das zweite Taktsignal empfängt, und (iii) einen vierten Ausgangsanschluss, der das synchronisierte Funktionssignal ausgibt, aufweist, wobei das synchronisierte Funktionssignal eine verzögerte Version des zweiten Flop-Ausgangssignals ist, und wobei das zweite Flop-Ausgangssignal um einen Taktzyklus des zweiten Taktsignals verzögert wird, um das synchronisierte Funktionssignal auszugeben.

## Revendications

1. Système à domaines d'horloge multiples, comprenant :
un circuit synchroniseur (106) comprenant :
un circuit logique séquentiel (202) configuré pour recevoir (i) un signal fonctionnel qui est généré sur la base d'un premier signal d'horloge, (ii) un deuxième signal d'horloge, et (iii) un signal de référence, et délivrer un signal logique, le premier signal d'horloge et le deuxième signal d'horloge étant associés respectivement à un premier domaine d'horloge et à un deuxième domaine d'horloge, le signal logique constituant une version étendue du signal fonctionnel de sorte que le signal logique est mis à un état logique en réponse à la mise à un état logique du signal fonctionnel, et reste à l'état logique pendant une durée prédéterminée après le passage du signal fonctionnel à un autre état logique, et la durée prédéterminée étant déterminée sur la base du deuxième signal d'horloge ; et
un étage de synchronisation (204) qui est couplé au circuit logique séquentiel (202), et configuré pour recevoir le signal logique et le deuxième signal d'horloge et délivrer un signal fonctionnel synchronisé qui est synchrone avec le deuxième signal d'horloge ;
dans lequel le circuit logique séquentiel (202) comprend une première bascule (206a) et une deuxième bascule (206b) qui sont couplées en série, la première bascule (206a) ayant (i) une première borne d'entrée configurée pour recevoir le signal de référence, (ii) une première borne de commande configurée pour recevoir le signal fonctionnel, (iii) une première borne d'horloge configurée pour recevoir le deuxième signal d'horloge, et (iv) une première borne de sortie configurée pour délivrer un premier signal de sortie de bascule, et la deuxième bascule (206b) ayant (i) une deuxième borne d'entrée configurée pour recevoir le premier signal de sortie de bascule, (ii) une deuxième borne de commande configurée pour recevoir le signal fonctionnel, (iii) une deuxième borne d'horloge configurée pour recevoir le deuxième signal d'horloge, et (iv) une deuxième borne de sortie configurée pour délivrer le signal logique ; et
dans lequel l'étage de synchronisation (204) comprend :
une troisième bascule (208a) ayant (i) une troisième borne d'entrée configurée pour recevoir le signal logique, (ii) une troisième borne d'horloge configurée pour recevoir le deuxième signal d'horloge, et (iii) une troisième borne de sortie configurée pour délivrer un deuxième signal de sortie de bascule, le deuxième signal de sortie de bascule constituant une version retardée du signal logique ; et
une quatrième bascule (208b) ayant (i) une quatrième borne d'entrée configurée pour recevoir le deuxième signal de sortie de bascule, (ii) une quatrième borne d'horloge configurée pour recevoir le deuxième signal d'horloge, et (iii) une quatrième borne de sortie configurée pour délivrer le signal fonctionnel synchronisé, le signal fonctionnel synchronisé constituant une version retardée du deuxième signal de sortie de bascule, et le deuxième signal de sortie de bascule étant retardé d'un cycle d'horloge du deuxième signal d'horloge pour délivrer le signal fonctionnel synchronisé.

2. Système à domaines d'horloge multiples selon la revendication 1, dans lequel la première borne de commande et la deuxième borne de commande de la première bascule et de la deuxième bascule sont des bornes de mise à un qui reçoivent respectivement le signal fonctionnel, dans lequel le signal de référence est reçu à un état logique bas, et dans lequel l'état logique auquel sont mis le signal fonctionnel et le signal logique correspond à un état logique haut et l'état logique auquel passe le signal fonctionnel correspond à un état logique bas.

3. Système à domaines d'horloge multiples selon la revendication 2, comprenant en outre un premier générateur de signal de référence qui est configuré pour être couplé au circuit logique séquentiel, et générer et fournir le signal de référence à l'état logique bas au circuit logique séquentiel.

4. Système à domaines d'horloge multiples selon l'une quelconque des revendications 2 ou 3, dans lequel, lorsque le signal fonctionnel est à l'état logique haut, le premier signal de sortie de bascule est à un état logique haut, et dans lequel, lorsque le signal fonctionnel passe ensuite de l'état logique haut à l'état logique bas, le premier signal de sortie de bascule reste à l'état logique haut jusqu'à ce que le deuxième signal d'horloge passe d'un état logique à un autre état logique.

5. Système à domaines d'horloge multiples selon la revendication 4, dans lequel, lorsque le signal fonctionnel est à l'état logique haut, le signal logique est à l'état logique haut, dans lequel, lorsque le signal fonctionnel passe ensuite de l'état logique haut à l'état logique bas, le signal logique reste à l'état logique haut tandis que le premier signal de sortie de bascule est à l'état logique haut, et dans lequel, lorsque le premier signal de sortie de bascule passe ensuite de l'état logique haut à un état logique bas, le signal logique reste à l'état logique haut jusqu'à ce que le deuxième signal d'horloge passe d'un état logique à un autre état logique.

6. Système à domaines d'horloge multiples selon l'une quelconque des revendications 1 à 5, dans lequel la première borne de commande et la deuxième borne de commande de la première bascule et de la deuxième bascule sont des bornes de remise à zéro qui reçoivent respectivement le signal fonctionnel, dans lequel le signal de référence est reçu à un état logique haut, et dans lequel l'état logique auquel sont mis le signal fonctionnel et le signal logique correspond à un état logique bas et l'état logique auquel passe le signal fonctionnel correspond à un état logique haut.

7. Système à domaines d'horloge multiples selon la revendication 6, comprenant en outre un deuxième générateur de signal de référence qui est configuré pour être couplé au circuit logique séquentiel, et générer et fournir le signal de référence à l'état logique haut au circuit logique séquentiel.

8. Système à domaines d'horloge multiples selon l'une quelconque des revendications 6 ou 7, dans lequel, lorsque le signal fonctionnel est à l'état logique bas, le premier signal de sortie de bascule est à un état logique bas, et dans lequel, lorsque le signal fonctionnel passe ensuite de l'état logique bas à l'état logique haut, le premier signal de sortie de bascule reste à l'état logique bas jusqu'à ce que le deuxième signal d'horloge passe d'un état logique à un autre état logique.

9. Système à domaines d'horloge multiples selon la revendication 8, dans lequel, lorsque le signal fonctionnel est à l'état logique bas, le signal logique est à l'état logique bas, dans lequel, lorsque le signal fonctionnel passe ensuite de l'état logique bas à l'état logique haut, le signal logique reste à l'état logique bas tandis que le premier signal de sortie de bascule est à l'état logique bas, et dans lequel, lorsque le premier signal de sortie de bascule passe ensuite de l'état logique bas à un état logique haut, le signal logique reste à l'état logique bas jusqu'à ce que le deuxième signal d'horloge passe d'un état logique à un autre état logique.

10. Système à domaines d'horloge multiples selon l'une quelconque des revendications précédentes, dans lequel la durée prédéterminée est supérieure à un cycle d'horloge du deuxième signal d'horloge.

11. Système à domaines d'horloge multiples selon l'une quelconque des revendications précédentes, dans lequel le signal fonctionnel synchronisé constitue une version retardée du signal logique, et dans lequel un retard entre le signal fonctionnel synchronisé et le signal logique est supérieur à un cycle d'horloge du deuxième signal d'horloge.

12. Système à domaines d'horloge multiples selon l'une quelconque des revendications précédentes, comprenant en outre un premier circuit fonctionnel associé au premier domaine d'horloge, couplé au circuit logique séquentiel, et configuré pour générer et fournir le signal fonctionnel au circuit logique séquentiel.

13. Procédé de synchronisation pour un système à domaines d'horloge multiples, le procédé de synchronisation comprenant :
la réception, par un circuit logique séquentiel (202) d'un circuit synchroniseur (106), de (i) un signal fonctionnel qui est généré sur la base d'un premier signal d'horloge, (ii) un deuxième signal d'horloge, et (iii) un signal de référence, le premier signal d'horloge et le deuxième signal d'horloge étant associés respectivement à un premier domaine d'horloge et à un deuxième domaine d'horloge, le circuit logique séquentiel (202) comprenant une première bascule (206a) et une deuxième bascule (206b) couplées en série, la première bascule (206a) ayant (i) une première borne d'entrée qui reçoit le signal de référence, (ii) une première borne de commande qui reçoit le signal fonctionnel, (iii) une première borne d'horloge qui reçoit le deuxième signal d'horloge, et (iv) une première borne de sortie qui délivre un premier signal de sortie de bascule, et la deuxième bascule (206b) ayant (i) une deuxième borne d'entrée qui reçoit le premier signal de sortie de bascule, (ii) une deuxième borne de commande qui reçoit le signal fonctionnel, (iii) une deuxième borne d'horloge qui reçoit le deuxième signal d'horloge, et (iv) une deuxième borne de sortie qui délivre le signal logique ;
la délivrance, par le circuit logique séquentiel (202), d'un signal logique sur la base du signal fonctionnel, du deuxième signal d'horloge, et du signal de référence, le signal logique constituant une version étendue du signal fonctionnel de sorte que le signal logique est mis à un état logique en réponse à la mise à un état logique du signal fonctionnel et reste à l'état logique pendant une durée prédéterminée après le passage du signal fonctionnel à un autre état logique, et la durée prédéterminée étant déterminée sur la base du deuxième signal d'horloge ;
la réception, par un étage de synchronisation (204) du circuit synchroniseur (106), du signal logique et du deuxième signal d'horloge ; et
la délivrance, par l'étage de synchronisation (204), sur la base du signal logique et du deuxième signal d'horloge, d'un signal fonctionnel synchronisé qui est synchrone avec le deuxième signal d'horloge, l'étage de synchronisation (204) comprenant :
une troisième bascule (208a) ayant (i) une troisième borne d'entrée qui reçoit le signal logique, (ii) une troisième borne d'horloge qui reçoit le deuxième signal d'horloge, et (iii) une troisième borne de sortie qui délivre un deuxième signal de sortie de bascule, le deuxième signal de sortie de bascule constituant une version retardée du signal logique ; et
une quatrième bascule (208b) ayant (i) une quatrième borne d'entrée qui reçoit le deuxième signal de sortie de bascule, (ii) une quatrième borne d'horloge qui reçoit le deuxième signal d'horloge, et (iii) une quatrième borne de sortie qui délivre le signal fonctionnel synchronisé, le signal fonctionnel synchronisé constituant une version retardée du deuxième signal de sortie de bascule, et le deuxième signal de sortie de bascule étant retardé d'un cycle d'horloge du deuxième signal d'horloge pour délivrer le signal fonctionnel synchronisé.
